# EUROPEAN PATENT APPLICATION

(11) **EP 4 697 076 A2**
(43) Date of publication of application: **18.02.2026**
(21) Application number: 25223239.2
(22) Date of filing: 18.10.2022
(51) Int. Cl.: G02B 17/00

(54) **VERTICAL MECHANICAL STOPS TO PREVENT LARGE OUT-OF-PLANE DISPLACEMENTS OF A MICRO-MIRROR AND METHODS OF MANUFACTURE**

(30) Priority: 01.11.2021 US 202163263373 P; 30.09.2022 US 202217937104
(62) Divisional of application: 22888381.5
(71) Applicant: Calient.AI Inc., Goleta, CA 93117 (US)
(72) Inventor: MILLER, Scott, A., Goleta, 93117 (US)
(74) Representative: Müller-Boré & Partner Patentanwälte PartG mbB

(57) **Abstract**

A mirror array comprising a movable mirror is described. The movable mirror including a stationary frame including a cavity and a movable frame in the cavity. The movable frame is suspended from the stationary frame by a first stationary frame flexure and a second stationary frame flexure. The movable mirror further includes a central stage in the cavity. The mirror array further comprises a lid wafer covering the movable mirror and a first protrusion on the lid wafer, wherein the first protrusion extends towards the movable mirror.

## Description

### CROSS REFERENCE TO RELATED APPLICATIONS

This application claims priority to U.S. Patent Application 17/937,104 filed September 30, 2022, which claims the benefit of U.S. Provisional Application No. 63/263,373, filed November 1, 2021**,** entitled **VERTICAL MECHANICAL STOPS TO PREVENT LARGE OUT-OF-PLANE DISPLACEMENTS OF A MICROMIRROR** which applications are incorporated herein in their entirety by reference.

### BACKGROUND

Technical Field: This disclosure relates to microelectromechanical systems (MEMS) mirror arrays and methods of manufacturing the MEMS mirror arrays that reduces and/or constrains out-of-plane displacements caused by shock.

Background: A MEMS (microelectromechanical systems) device is a micro-sized mechanical structure having electrical circuitry and is fabricated using conventional integrated circuit (IC) fabrication methods. One type of MEMS device is a microscopic gimbaled mirror device. A gimbaled mirror device includes a mirror component, which is suspended off a substrate, and is able to pivot about a gimbal due to electrostatic actuation. Electrostatic actuation creates an electric field that causes the mirror component to pivot. By allowing the mirror component to pivot, the mirror component is capable of having an angular range of motion in which the mirror component can redirect light beams to varying positions.

An optical switch is a switching device that couples light beams from an input fiber to an output fiber. Typically, the light beams from an input fiber are collimated and directed toward a desired location such as an output fiber. A movable mirror (e.g., a gimbaled mirror) in a switch mirror array redirects the light beams to desired locations.

Inside the optical switch, the mirrors in the array may need to rotate 10 - 20 degrees or more to direct the light beams to the desired locations. The mirrors need sufficient space above and below to allow these rotations. However, having this much space above and below the mirrors allows the mirrors to also move linearly in the vertical (out-of-plane) direction. The mirror flexures are designed to prevent this undesired linear, out-of-plane motion under normal operating conditions. When the optical switch is being handled during shipment or installation, for example, the optical switch could be dropped or impacted with sufficient force to cause the mirrors to undergo large out-of-plane deflections. This may damage mirrors in the switch array resulting in them being inoperable.

What is needed are MEMS mirror arrays and methods of manufacturing the MEMS mirror arrays that reduces and/or constrains out-of-plane displacements caused by shock.

### SUMMARY

Disclosed are MEMS mirror arrays and methods of manufacturing the MEMS arrays that constrains out-of-plane displacement caused by shock which reduces the likelihood of damage. Also disclosed are MEMS mirror arrays and methods of manufacturing the arrays that constrains out-of-plane displacements while still allowing large angular rotations needed for optical switching.

One aspect of the disclosure provides a mirror array. The mirror array includes a lid, a base, and a movable mirror between the lid and the base. The movable mirror includes a stationary frame including a cavity, a movable frame in the cavity, and a central stage in the cavity. The mirror array also includes a first protrusion on the base. The first protrusion overlaps with the central stage in a first direction.

Implementations of the disclosure may include one or more of the following optional features. The central stage can include a bottom portion facing the first protrusion. Additionally, the first protrusion can be spaced apart from the bottom portion of the central stage by a predetermined distance. The predetermined distance between the first protrusion and the bottom portion of the central stage is between 3µm and 15µm.

Optionally, the mirror array further may include a second protrusion on the lid and a third protrusion on the lid. The second protrusion and the third protrusion can be configured to extend towards the base. The mirror array can also include a first stationary frame flexure and a second stationary frame flexure. The first stationary frame flexure and the second stationary frame flexure suspend the movable frame from the stationary frame. The second protrusion can be configured to overlap with the first stationary frame flexure in the first direction, and the third protrusion can be also configured to overlap with the second stationary frame flexure in the first direction. The second protrusion can also be positioned apart from the first stationary frame flexure by a predetermined distance. The predetermined distance between the second protrusion and the first stationary frame flexure is between 3µm and 15µm. The third protrusion can also be positioned apart from the second stationary frame flexure by a predetermined distance. The predetermined distance between the third protrusion and the secondary stationary frame flexure is also between 3µm and 15µm. The second protrusion and the third protrusion can be positioned so that the second protrusion and the third protrusion are non-overlapped with the central stage in the first direction.

The mirror array is further configurable to include a fourth protrusion on the base and a fifth protrusion on the base. The first protrusion can be positioned between the fourth protrusion and the fifth protrusion. Additionally, the fourth protrusion can be configured to support a first support member, while the fifth protrusion is configured to support a second support member. The central stage can also include a bottom portion extending towards the first protrusion, wherein the bottom portion is positioned between the first support member and the second support member.

Another aspect of the disclosure provides a mirror array. The mirror array includes a movable mirror and a lid wafer covering the movable mirror. The movable mirror also includes a stationary frame including a cavity, a movable frame in the cavity, and a central stage in the cavity. The movable frame can be suspended from the stationary frame by a first stationary frame flexure and a second stationary frame flexure. The mirror array can also include a first protrusion on the lid wafer. The first protrusion is extended towards the movable mirror.

Implementations of the disclosure may include one or more of the following optional features. The first protrusion can overlap with the first stationary frame flexure in a first direction. A gap can be provided between the first protrusion and the first stationary frame flexure that is between 3µm and 15µm. The mirror array can further include a second protrusion on the lid wafer. The second protrusion can be positioned to overlap with the second stationary frame flexure in the first direction. A gap can be provided between the second protrusion and the second stationary frame flexure that is between 3µm and 15µm.

The mirror array is further configurable to include a base wafer and a third protrusion on the base wafer. The third protrusion can also overlap with the central stage in the first direction. The third protrusion can also be spaced apart from a bottom portion of the central stage by a predetermined distance, such as 3µm and 15µm.

Both the foregoing general description and the following detailed description are exemplary and explanatory only and are not restrictive of the disclosed embodiments, as claimed.

### INCORPORATION BY REFERENCE

All publications, patents, and patent applications mentioned in this specification are herein incorporated by reference to the same extent as if each individual publication, patent, or patent application was specifically and individually indicated to be incorporated by reference.
US 5,501,893 A issued 3/26/1996 to Laermer et al.;
US 5,635,739 A issued 6/3/1997 to Grieff et al.;
US 5,696,619 A issued 12/9/1997 to Knipe et al.;
US 6,430,333 B1 issued 8/6/2002 to Little et al.;
US 6,664,706 B1 issued 12/16/2003 to Hung et al.;
US 6,914,711 B2 issued 7/5/2005 to Novotny et al.;
US 7,092,141 B2 issued 8/15/2006 to Kim et al.;
US 7,261,826 B2 issued 8/28/2007 to Adams et al.;
US 7,330,297 B2 issued 2/12/2008 to Noh et al. and
BEHIN, et al., Magnetically Actuated Micromirrors for FiberOptic Switching, 1998-12-31.

### BRIEF DESCRIPTION OF THE DRAWINGS

The novel features of the invention are set forth with particularity in the appended claims. A better understanding of the features and advantages of the present invention will be obtained by reference to the following detailed description that sets forth illustrative embodiments, in which the principles of the invention are utilized, and the accompanying drawings of which:
**FIG. 1** illustrates a MEMS mirror array including a plurality of movable mirrors;
**FIG. 2** illustrates the wafer after a release etch separates portions of the structure and after the attachment of the lid wafer;
**FIGS. 3A-B** illustrates a maximum out-of-plane deflection of a top surface vs. rotation angles **(****FIG. 3A****)** and a minimum out-of-plane deflection of a bottom surface vs. rotation angles **(****FIG. 3B****);**
**FIG. 4** illustrates a partial cross-section of a mirror array;
**FIG. 5** illustrates a partial cross-section of a mirror array with mechanical stops;
**FIG. 6** illustrates a movable mirror with a base mechanical stop location identified;
**FIGS. 7A-H** illustrates a process for fabricating a base wafer;
**FIG. 8** illustrates a partial cross-section of a mirror array with a base wafer and a lid wafer;
**FIG. 9** illustrates a movable mirror with an indication of locations for mechanical stops; and
**FIGS. 10A-I** illustrates a process for fabricating the lid wafer.

### DETAILED DESCRIPTION

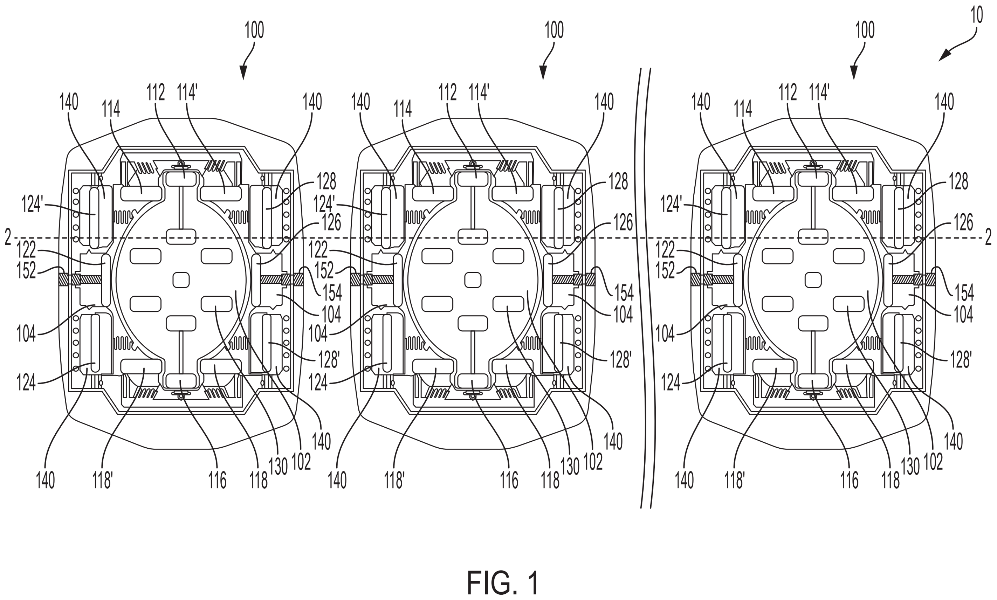

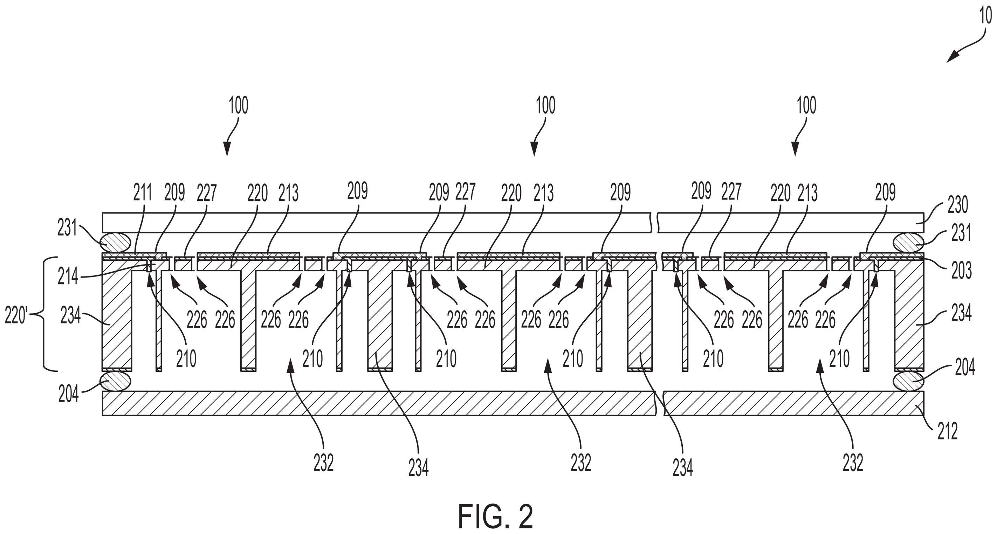

**FIG. 1** illustrates a partial MEMS mirror array **10** including a plurality of MEMS mirrors **100** (also referred as actuators). At each end of a stage or frame, actuator **100** uses a single movable blade, with two corresponding fixed blades as an actuation mechanism structure to enable rotation. Actuator **100** uses two such actuation mechanism structures per stage and two such actuation mechanism structures per frame. A plurality of blades are provided. A first blade **112** is coupled to stage **102** (central stage **220 in** **FIGS. 2****,** **4****,** **5****,** and **8****)** and is flanked on either side by a pair of first flanking blades **114, 114'** which are coupled to moveable frame **104** (moveable frame **227 in** **FIGS. 2****,** **4****,** **5****,** and **8****)** on opposite ends of first blade **112.** Stage **102** is pivotally coupled to moveable frame **104** such that first blade **112** is configured to move relative to first flanking blades **114, 114'.** When a potential difference is applied between first blade **112** and one of the first flanking blades **114, 114',** an attraction is generated between the blades causing stage **102** to pivot. For example, first blade **112** may be held at a ground potential while an active voltage is applied to either of the first flanking blades **114, 114'.** The application of an active voltage to first flanking blade **114,** for example, will attract the first blade **112,** thereby causing stage **102** to rotate or pivot in a corresponding direction. Similarly, the application of an active voltage to first flanking blade **114'** will attract first blade **112** and cause stage **102** to rotate or pivot in an opposite direction to that resulting from the attraction to first flanking blades **114.**

A second blade **116** is coupled on end of stage **102** opposite the location of the first blade **112,** with a pair of second flanking blades **118,** 118' coupled to moveable frame **104** on opposite ends of second blade **116.** Second blade **116** moves relative to second flanking blades **118, 118'.** In order to provide the desired motion of stage **102** and to resist unwanted rotations, actuation voltages are applied concurrently with respect to first blade **112** and second blade **116.** For example, the range of motion for the stage **102** is between +15 degrees and -15 degrees, approximately. When the potential difference is applied between the second blade **116** and one of second flanking blades **118, 118',** an attraction is generated between the blades resulting in the rotation of stage **102** in a manner similar to that discussed above with respect to the first blade **112.** The use of actuation mechanisms in tandem on each end of stage **102** minimizes or reduces undesired twisting of the stage **102** to provide for more uniform rotation.

A similar actuation mechanism structure may be used for rotation of moveable frame **104.** For example, a first side blade **122** is coupled to moveable frame **104** and first side flanking blades **124, 124'are** coupled to stationary frame **140** (stationary frame **214** in **FIGS. 2****,** **4****,** **5****,** and **8****)** on opposite ends of first side blade **122.**

Moveable frame **104** is pivotally coupled to the stationary frame **140** such that first side blade **122** is configured to move relative to first side flanking blades **124, 124'.** When a potential difference is applied between the first side blade **122** and one of the first side flanking blades **124, 124',** an attraction is generated between the blades causing moveable frame **104** to pivot in a manner similar to that discussed above in relation to stage **102.** As shown, the moveable frame **104** is suspended from the stationary frame **140** by mirror flexure **152** (e.g., spring, first stationary frame flexure) and a second mirror flexure **154** (e.g., spring, second stationary frame flexure).

Second side blade **126** is coupled on the opposite end of moveable frame **104,** with second side flanking blades **128, 128'** coupled to stationary frame **140** on opposite ends of second side blade **126.** Second side blade **126** moves relative to second side flanking blades **128, 128'.** When the potential difference is applied between second side blade **126** and one of second side flanking blades **128, 128',** an attraction is generated between the blades facilitating the rotation of moveable frame **104.** The use of actuation mechanisms in tandem on each end of moveable frame **104** minimizes or reduces undesired twisting of the frame to provide for more uniform rotation. For example, the range of motion for the movable frame **104** is between +20 degrees and -20 degrees, approximately.

Alternatively, a stage **102** or moveable frame **104** may only have an actuation mechanism structure on a single end. For another embodiment, actuator **100** may have other actuation mechanism structures without departing from the scope of the disclosure.

For one embodiment, a plurality of elongated members **130** can be provided (e.g., elongated member **130)** which are coupled to the undersurface of stage **102** to stiffen the stage **102** and minimize or reduce top surface distortions. In addition, the elongated members **130** on stage **102** may be used to remove etch depth variations across the device. Elongated member **130** may be constructed similar to that of blades discussed herein. **FIG. 1** illustrates seven elongated members **130** where six of the elongated members have substantially the same length and are positioned off-center on the stage **102,** and the seventh elongated member **130** has a shorter length and is positioned centrally on the stage **102.** For example, the seventh elongated member **130** is approximately 10% to 75% shorter than other elongated members **130** (that are positioned "off-center").

For one embodiment, actuator **100** may be fabricated on a wafer level using semiconductor fabrication techniques, as discussed below. For such an embodiment, stationary frame **140** may be formed from a substrate, for example, constructed from silicon. Where all blades are directly driven by different control voltages, actuator **100** may use four voltages, plus a ground. With this arrangement, the number of conductive paths on a substrate quickly becomes very large as multiple actuators are combined to form an array. The low voltages required by the blade actuators discussed herein may allow for control circuitry to be fabricated into the substrate so that only control signals need be routed, rather than separate lines for each blade. This results in a significant reduction in lead count. Lower voltages may also reduce the necessity for spacing between leads to avoid arcing and cross-talk.

**FIG. 2** illustrates a partial cross-section of the mirror array **10** illustrated in **FIG. 1** along the lines **2-2** which illustrates a final structure release on the wafer topside using dry etching, which punctures through trenches **226** to suspend movable elements of the mirror **213** and the frame **227** (also referred as movable frame). In addition, the release etch promotes electrical isolation by separating, for example, the silicon of the frame **227** from the silicon of central stage **220** and stationary frame **214.** The vias **209** serve to connect the regions of silicon to the metal interconnects **211.** To completely seal the mirrors **213** from the outside environment, a lid wafer **230** is bonded to the device wafer **220',** preferably through the frit glass seal **231.** The lid wafer **230** is typically glass to allow incoming light to be transmitted with low loss in the mirror cavity **232,** reflect off of the surface of the mirror surface, and transmit out of the mirror cavity **232.**

The trenches **210** are filled with a dielectric material, which for one embodiment is silicon dioxide. The filled trenches **210** provide the electrical isolation between blades after the mirror is released. A dielectric layer **203** also remains on the surface of the device wafer **220'** and is planarized after the fill process to ease subsequent lithographic patterning and eliminate surface discontinuities. Structure release is accomplished at the upper surface (topside) of the device wafer **220'** using dry etching, which punctures through a plurality of trenches **226** to suspend the movable elements of the mirror **213** and the frame **227.** Support webbing **234** (also referred as support member) is also provided. As shown, the bottom portion of the central stage **220** is between the support webbings **234.** A base wafer **212** is bonded to the device wafer **220'** to protect the blades after release. A hermetic seal **204** can surround the entire mirror array. The hermetic seal **204** can be formed by the frit material between the base wafer **212** and the device wafer **220'.**

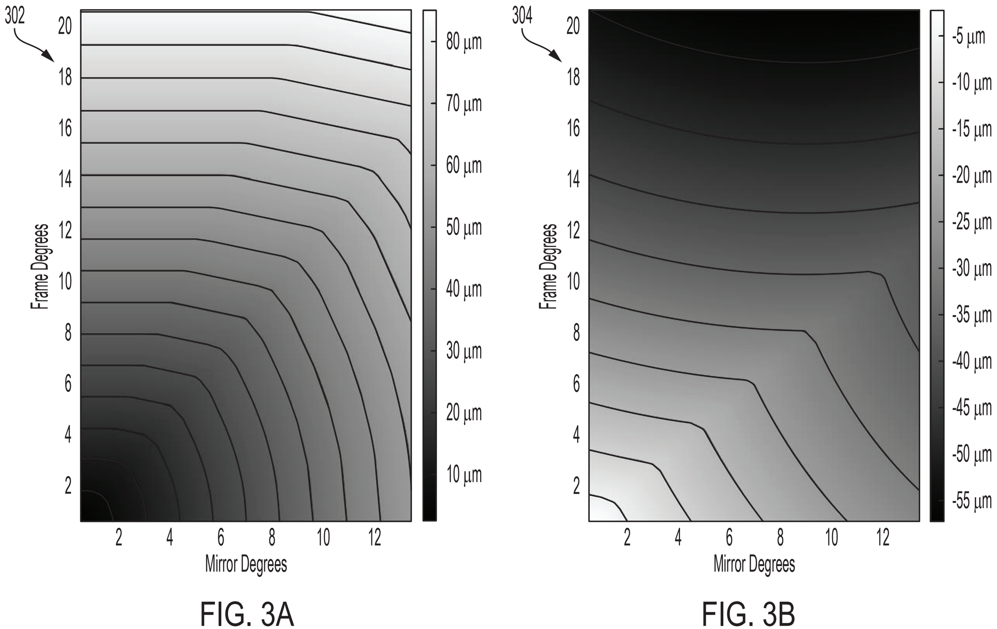

**FIGS. 3A-B** illustrates a maximum out-of-plane deflection of a top surface (of mirror **213)** vs. rotation angles **302** and a minimum out-of-plane deflection of a bottom surface (of the central stage **220)** vs. rotation angles **304.** The maximum out-of-plane deflection in **FIG. 3A** reflects frame degrees from 0-20 on a y-axis and mirror degrees of 0-14 in an x-axis. The values range from 0 µm to 85 µm, with the lowest values being closest to the area around 0 frame degrees and 0 mirror degrees and the high values being from about 19-20 frame degrees and 0-14 mirror degrees. The minimum out-of-plane deflection of a bottom surface vs. rotation angles in **FIG. 3B** reflects frame degrees from 0-20 on a y-axis and mirror degrees of 0-14 in an x-axis. The values range from -60 µm to 0 µm, with the highest values being closest to the area around 0 frame degrees and 0 mirror degrees and the lowest values being from about 19-20 frame degrees and 0-14 mirror degrees.

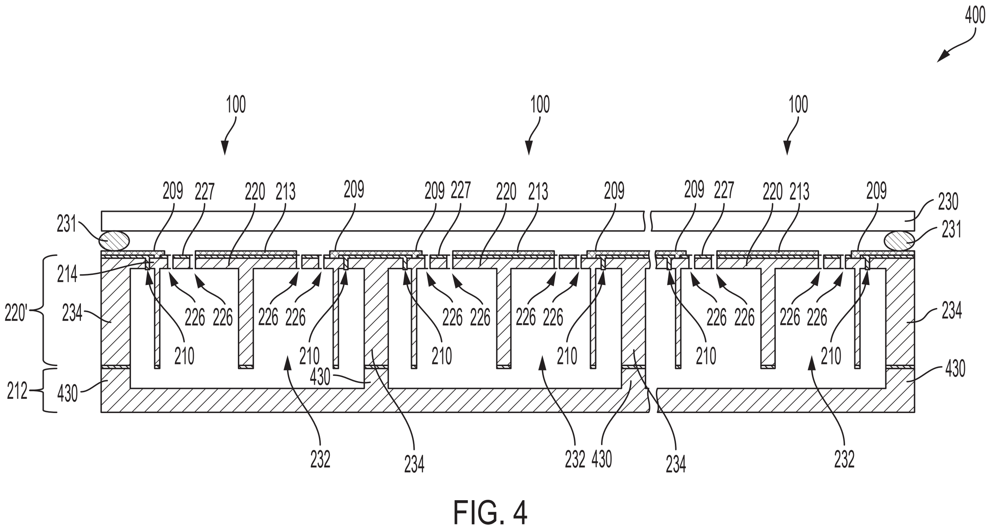

**FIG. 4** illustrates a partial cross-section of a mirror array **400** with support anchors **430.** As shown, the base wafer **212** includes the support anchors **430.** The support anchors **430** (also referred as protrusions or base protrusions) are positioned below the support webbings **234.** Accordingly, each of the support anchors **430** of the base wafer **212** overlaps with a corresponding support webbing **234** in a first direction (e.g., vertical direction). As a result, the support anchors **430** support the support webbings **234.** As shown, the support anchors **430** also support the device wafer **220'.** The base wafer **212** is bonded to the support anchors **430** via thermal compression, eutectic, or fusion bonding. As a result, the base wafer **212** is bonded to the device wafer **220'.**

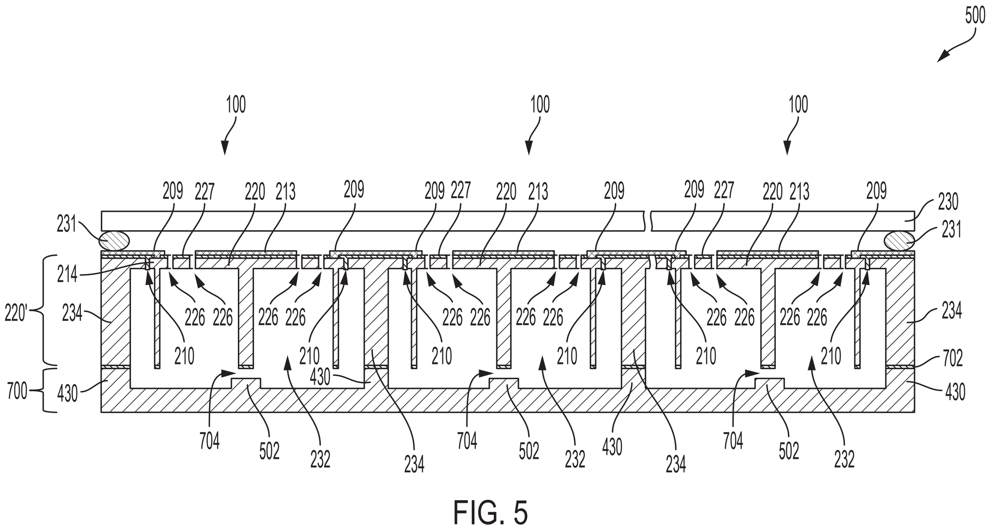

**FIG. 5** illustrates a partial cross-section of a mirror array **500** with mechanical stops **502** (also referred as protrusions or base protrusions) on a base wafer **700** (e.g., silicon wafer, substrate). As shown, each of the mechanical stops **502** overlaps with a corresponding central stage **220**/mirror **213** in the first direction. As shown, each of the central stages 220 has a bottom portion facing a corresponding mechanical stop **502.** A gap **704** is provided between the bottom of the device wafer **220'** (base or bottom portion of the central stage **220)** and the top surface of the mechanical stop **502.** As shown, the mechanical stop **502** is between the support anchors **430.**

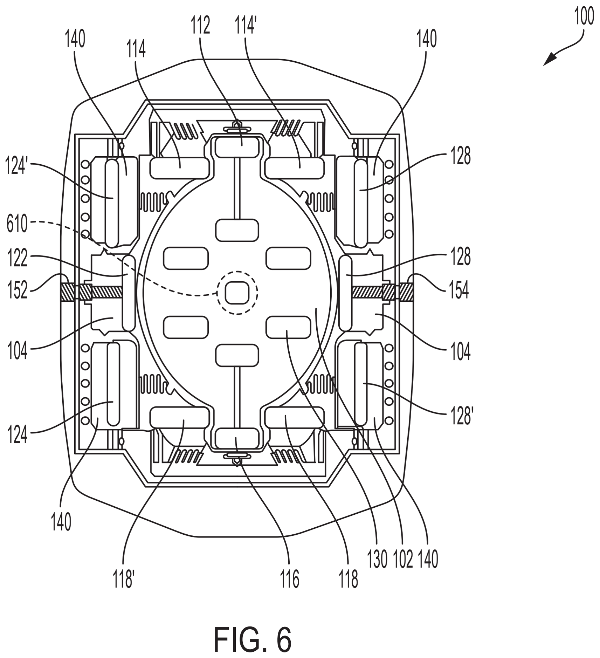

**FIG. 6** illustrates a central stage **102** (central stage **220** in **FIGS. 2****,** **4****,** **5****,** and **8****),** which supports a mirror **213,** with a location **610** for the mechanical stop **502** of **FIG. 5****.** For example, the mechanical stops **502** can be located directly under the center of each mirror **213/central** stage **220.** The gap **704** between the bottom of the center loading structure of the mirror **213** (base or bottom portion of the central stage **220)** and the mechanical stop **502** can be between 3 µm and 15 µm.

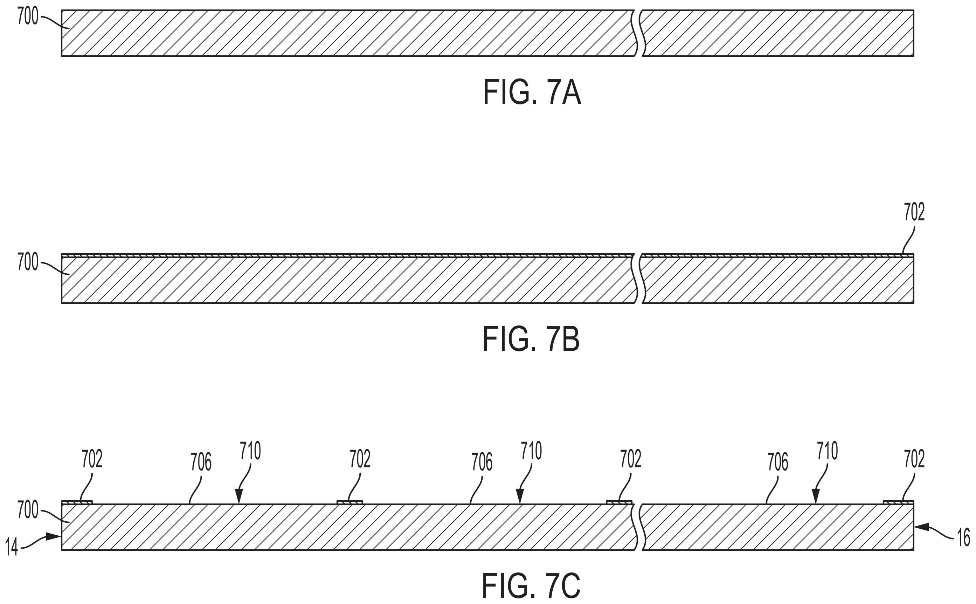

**FIGS. 7A-H** illustrates a process for fabricating a base wafer **700.** A base wafer **700** is shown in **FIG. 7A****.** A hard mask layer **702** is deposited on the base wafer **700** as shown in **FIG. 7B****.** The hard mask layer **702** can be silicon dioxide, silicon nitride, aluminum, or another material that can serve as a mask for deep reactive ion etching of silicon. The hard mask layer **702** can also serve as the bonding material later in the process. Turning to **FIG. 7C****,** hard mask layer **702** is patterned to allow for the etching of the cavity below the mirror **213.** The patterning results in the hard mask layer **702** having spaces **706** between a first end of the silicon wafer **14** and a second end of the silicon wafer **16.** The spaces **706** expose top surfaces **710** of the base wafer **700.** The patterning is done using standard photolithography and etching methods.

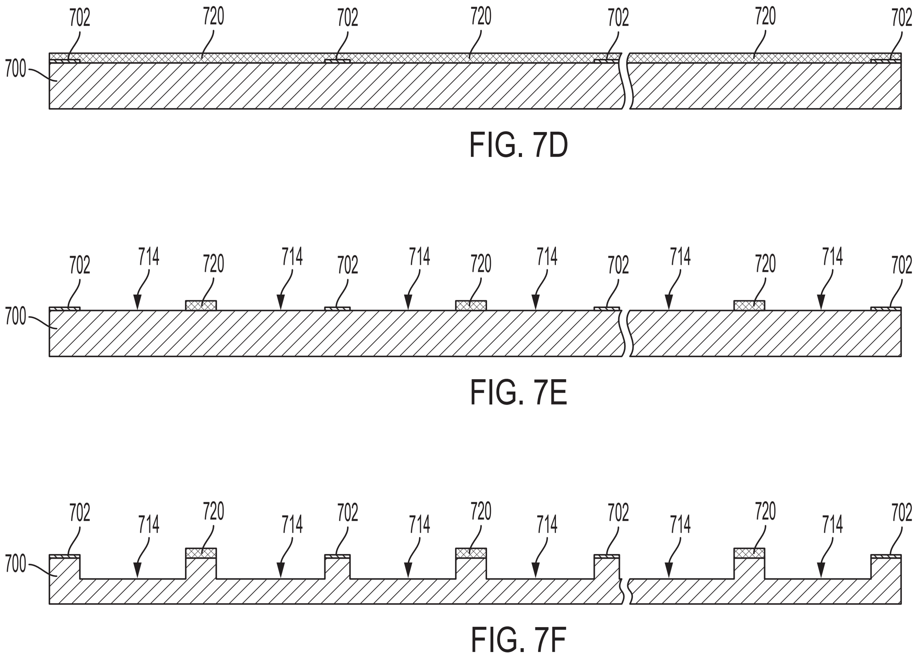

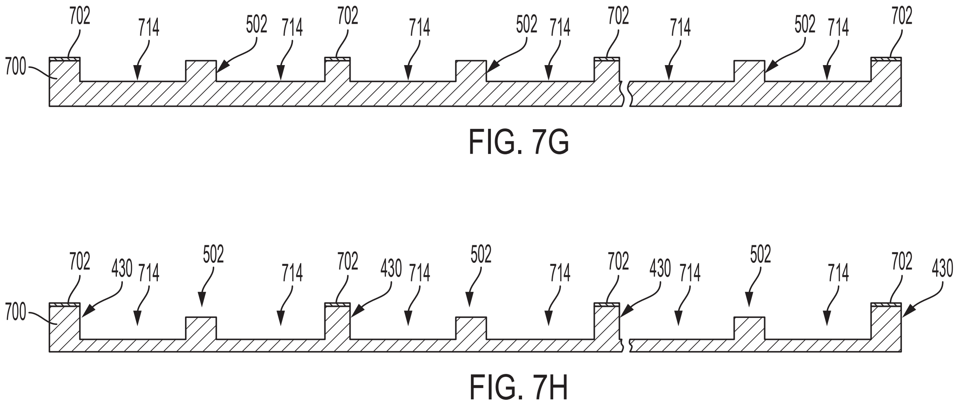

A coating of photoresist material **720** (also referred as photoresist layer) is deposited on the hard mask layer **702** and the base wafer **700** as shown in **FIG. 7D****.** The photoresist material **720** is patterned as shown in **FIG. 7E** to define the locations of the mechanical stop **502** in **FIG. 5****.** In **FIG. 7F****,** deep reactive ion etching is used to partially etch into the base wafer **700.** As a result, the deep reactive ion etching etches exposed surfaces **714** of base wafer **700.** The depth of this etch can be determined by the final desired depth of the cavity minus the gap desired between each of the mechanical stops **502** and the bottom of the center loading structure on a corresponding mirror **213.** For example, the final desired depth of the cavity is equal or greater than 55µm and less than the thickness of the base wafer **700.** The photoresist material **720** is stripped from the silicon wafer **700** as shown in **FIG. 7G** to start forming the gaps **704.** Deep reactive ion etching is then used to complete the etching of the cavity to a final desired depth as shown in **FIG. 7H****.** As shown in **FIG. 7H****,** during the deep reactive ion etching process, top surfaces of the mechanical stops **502** are also etched. Accordingly, the height for each of the mechanical stops **502** is adjusted to a final desired height. As a result, the gap **704** (e.g., gap between 3 µm and 15 µm) is formed between each of the mechanical stops **502** and the bottom of the center loading structure on the corresponding mirror **213** (base or bottom portion of the central stages **220).** Un-etched portions of the base wafer **700** covered by the hard mask layer **702** are the support anchors **430.** The hard mask layer **702** can remain on the base wafer **700** or be removed, depending on the bonding technique.

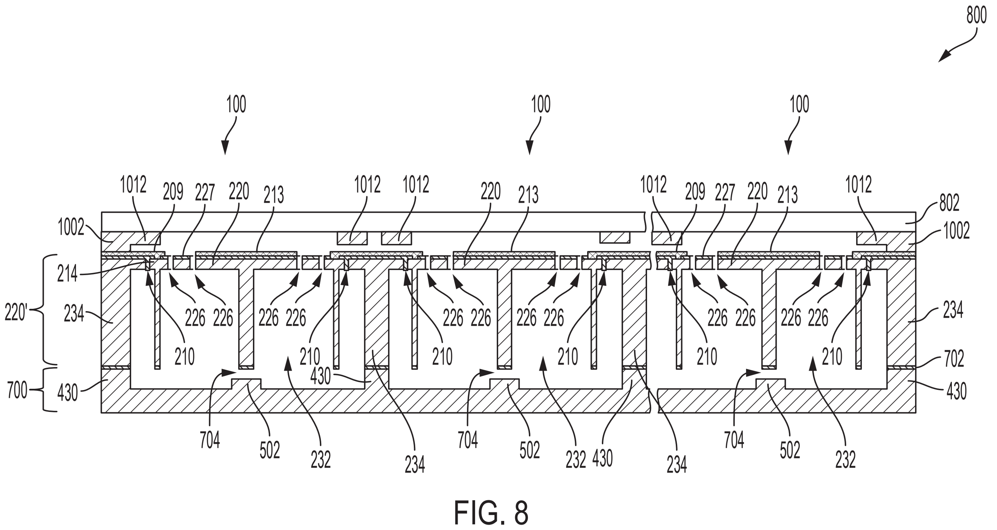

**FIG. 8** illustrates a partial cross-section of a mirror array **800** with a base wafer **700** and a lid wafer **802** (e.g., glass wafer). Mechanical stops **502** prevent a large downward out-of-plane deflection of the mirrors **213** and are fabricated on the base wafer **700** as described above. In addition, mechanical stops **1012** (also referred as protrusions or lid protrusions) to prevent large upward out-of-plane deflections are fabricated on the lid wafer **802.**

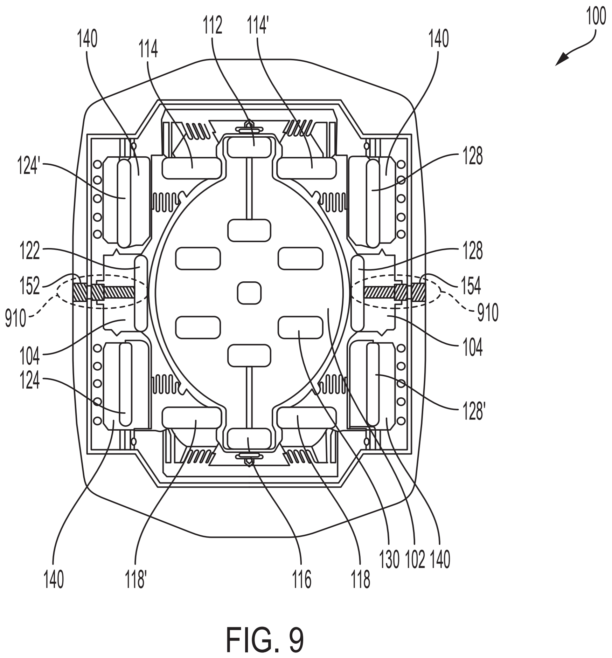

**FIG. 9** illustrates an indication of locations **910** for mechanical stops **1012.** The mechanical stops **1012** can be located directly above the center of each mirror's flexures **152, 154** (also referred as stationary frame flexures) as shown in **FIG. 9****.** In other words, each of the mechanical stops **1012** may overlap with a corresponding mirror's flexure **152, 154** in the first direction. Special care should be taken in the location of these mechanical stops **1012** to ensure that the mechanical stops **1012** will not block the light reflected from the mirrors **213** (e.g., mechanical stops **1012** nonoverlapping with the mirrors **213/central** stages **220).** A gap between the top of the mirror flexures **152, 154** and the mechanical stop **1012** can be between 3 µm - 15 µm.

As shown in **FIGS. 8** and **9****,** one aspect of the disclosure provides the mirror array **800.** As shown, the mirror array **800** includes a lid (lid wafer **802),** a base (base wafer **700),** and a movable mirror **100** between the lid (lid wafer **802)** and the base (base wafer **700).** The movable mirror **100** includes a stationary frame **214** including a cavity **232,** a movable frame **227** in the cavity **232,** and a central stage **220** in the cavity **232.** As shown, the mirror array **800** also includes a first protrusion (mechanical stop **502)** on the base (base wafer **700).** The first protrusion (mechanical stop **502)** overlaps with the central stage **220** in a first direction (e.g., vertical direction). As shown, the protrusion (mechanical stop **502)** is formed from the base (base wafer **700).** However, the first protrusion (mechanical stop **502)** may be formed from a separate layer on the base (base wafer **700).** As show, the central stage **220** includes a bottom portion facing the first protrusion (mechanical stop **502).** The first protrusion (mechanical stop **502)** is spaced apart from the bottom portion of the central stage **220** by a predetermined distance (e.g., distance between 3µm and 15µm).

As shown, the mirror array **800** also includes a second protrusion (mechanical stop **1012)** on the lid (lid wafer **802),** and a third protrusion (mechanical stop **1012)** on the lid (lid wafer **802).** The second protrusion (mechanical stop **1012)** and the third protrusion (mechanical stop **1012)** extend towards the base (base wafer **700).** As shown, the mirror array **800** also includes a first stationary frame flexure (mirror's flexure **152)** and a second stationary frame flexure (mirror's flexure **154).** The first stationary frame flexure (mirror's flexure **152)** and the second stationary frame flexure (mirror's flexure **154)** suspend the movable frame **227** from the stationary frame **214.** As shown, the second protrusion (mechanical stop **1012)** overlaps with the first stationary frame flexure (mirror's flexure **152)** in the first direction, and the third protrusion (mechanical stop **1012)** overlaps with the second stationary frame flexure (mirror's flexure **154)** in the first direction. As shown, the second protrusion (mechanical stop **1012)** is apart from the first stationary frame flexure (mirror's flexure **152)** by a predetermined distance (e.g., distance between 3µm and 15µm). As shown, the third protrusion (mechanical stop **1012)** is apart from the second stationary frame flexure (mirror's flexure **154)** by a predetermined distance (e.g., distance between 3µm and 15µm). As shown, the second protrusion (mechanical stop **1012)** and the third protrusion (mechanical stop **1012)** are non-overlapped with the central stage **220** in the first direction.

As shown, the mirror array **800** also includes a fourth protrusion (support anchor **430)** and a fifth protrusion (support anchor **430)** on the base (base wafer **700).** As shown, the fourth protrusion (support anchor **430)** and the fifth protrusion (support anchor **430)** are formed from the base (base wafer 700). However, the fourth protrusion (support anchor **430)** and the fifth protrusion (support anchor **430)** may be formed from a (separate) layer on the base (base wafer **700).** As shown, the first protrusion (support anchor **430)** is between the fourth protrusion (support anchor **430)** and the fifth protrusion (support anchor **430).** As shown, the fourth protrusion (support anchor **430)** is configured to support a first support member (support webbing **234),** and the fifth protrusion (support anchor **430)** is configured to support a second support member (support webbing **234).** As shown, the central stage **220** includes a bottom portion extending towards the first protrusion (mechanical stop **502).** As shown, the bottom portion of the central stage **220** is between the first support member (support webbing **234)** and the second support member (support webbing **234).**

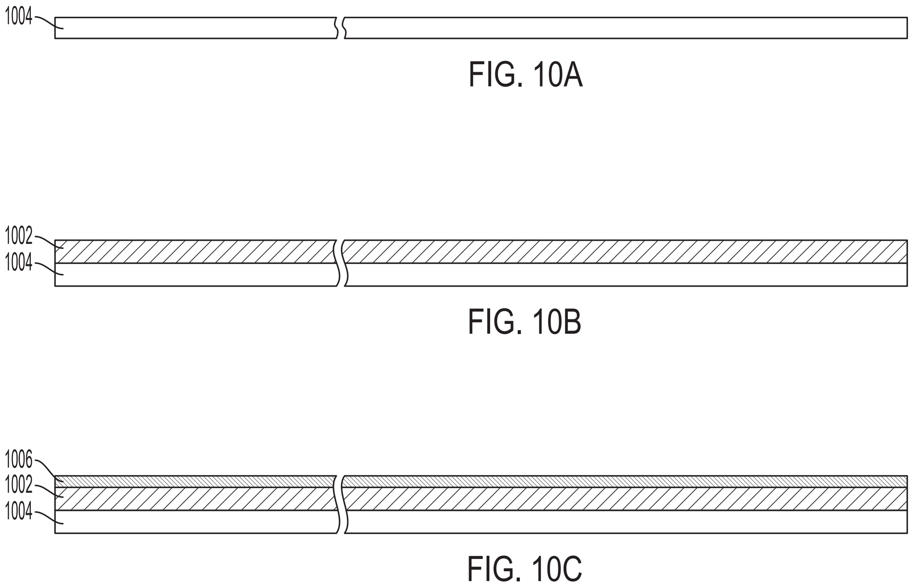

**FIGS. 10A-I** illustrates a manufacturing process for fabricating the lid wafer **802** (also referred as lid). A glass wafer **1004** (lid wafer **802** in **FIG. 8****)** as shown in **FIG. 10A** is provided. A silicon wafer **1002** (also referred as silicon substrate) is then fusion bonded to the glass wafer **1004** as shown in **FIG. 10B****.** A hard mask material **1006** (also referred as hard mask layer) is then deposited on the silicon wafer **1002.** This material can be silicon dioxide, silicon nitride, aluminum, or another material that can serve as a mask for deep reactive ion etching of silicon. The material can also serve as the bonding material later in the process.

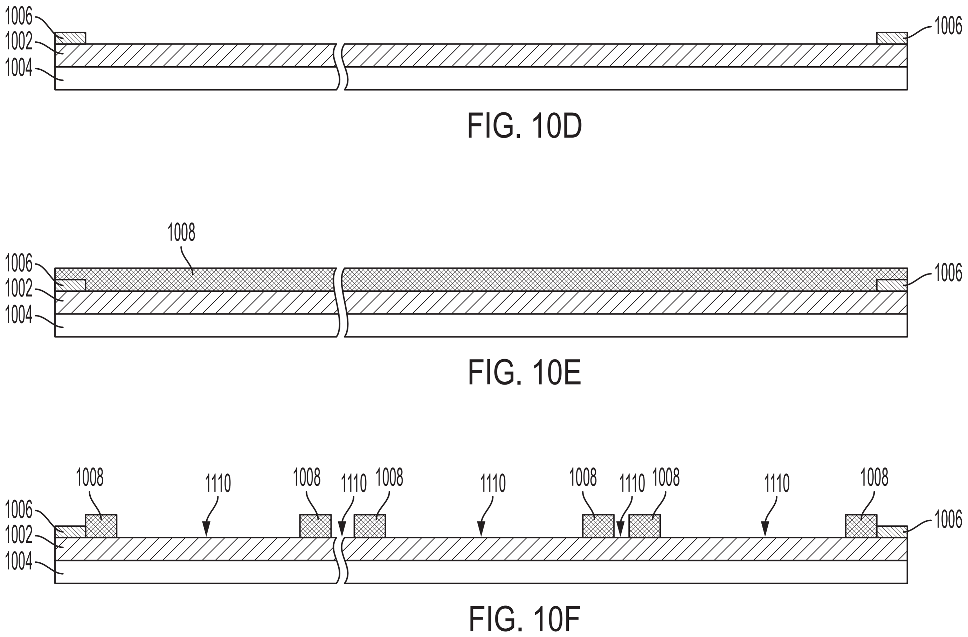

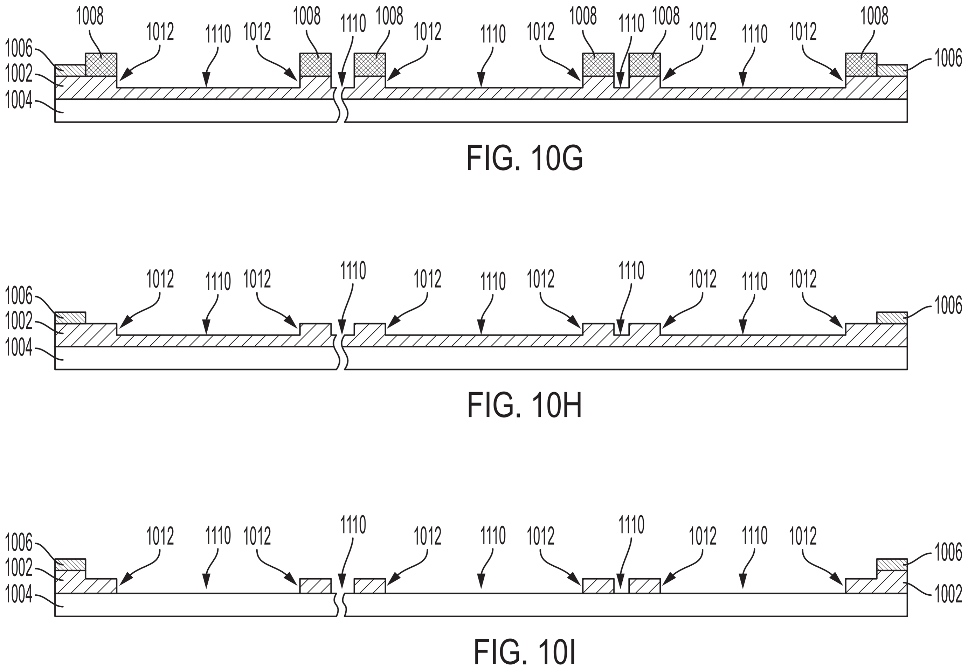

**FIG. 10D** illustrates the hard mask material **1006** patterned to allow for the etching of a cavity below the movable mirrors **100.** The patterning is done using standard photolithography and etching methods. Turning to **FIG. 10E****,** a coating of photoresist **1008** (also referred as photoresist layer) is deposited on the silicon wafer **1002** and the hard mask material **1006.** The photoresist **1008** is patterned to define the locations of the mechanical stop **1012** as shown in **FIG. 10F****.** Deep reactive ion etching is used to partially etch into the silicon wafer **1002** as shown in **FIG. 10G****.** The depth of this etch can be determined by thickness of the silicon wafer **1002** minus the gap desired between each of the mechanical stops **1012** and the top of a corresponding mirror flexure **152, 154.** As discussed above, for example, the desired gap distance is between 3µm and 15µm, approximately. The photoresist **1008** is stripped from the silicon wafer **1002** in **FIG. 10H****.** Deep reactive ion etching is then used once again, as shown in **FIG. 10I**, to complete the etching of the cavity to the final desired depth which clears the silicon and exposes the glass wafer surface **1110.** As shown in **FIG. 10I**, during the deep reactive ion etching process, top surfaces of the mechanical stops **1012** are also etched. Accordingly, the height for each of the mechanical stops **1012** is adjusted to a final desired height. At a result, the gap is formed between each of the mechanical stops **1012** and the corresponding mirror flexure **152, 154** as shown in **FIGS. 8** and **9****.** The hard mask material **1006** can remain on the silicon wafer **1002** or be removed, depending on the bonding technique. As shown in **FIG. 10I****,** the entire structure is lid wafer **802.**

As shown in **FIGS. 7A-H****,** **8**, **9**, and **10A-10I**, another aspect of the disclosure provides a fabrication method of the mirror array **800.** In particular, the disclosure provides a fabrication method of the lid (lid wafer **802)** as well as a fabrication method of a base (base wafer **700).** As shown in **FIG. 8****,** the mirror array **800** includes a plurality of movable mirrors **100** that are spaced apart from each other. As discussed, each of the plurality of movable mirrors **100** may include a stationary frame **214** including a cavity **232,** a movable frame **227** in the cavity **232,** and a central stage **220** in the cavity **232.** As shown, the movable frame **227** is suspended from the stationary frame **214** by a first stationary frame flexure **152** and a second stationary frame flexure **154.** As shown in **FIGS. 8****,** **9****,** and **10A****-10I**, the lid (lid wafer **802)** may be formed separately from the plurality of movable mirrors **100** and the base (base wafer **700).** After forming the lid (lid wafer **802)** as shown in FIGS. **10A-10I****,** the lid (lid wafer **802)** can be placed on the plurality of movable mirrors **100.** In some circumstances, the plurality of movable mirrors **100** is placed under the lid (lid wafer **802).** As shown, when the lid (lid wafer **802)** is covering the plurality of movable mirrors **100,** each of the protrusions (mechanical stops **1012)** on the lid (lid wafer **802)** overlaps with one of the stationary frame flexures **152, 154** in a first direction (e.g., vertical direction). As shown in **FIGS. 7A-7H****,** **8****,** **9****,** and **10A-10I**, the base (base wafer **700)** may be formed separately from the plurality of movable mirrors **100** and the lid (lid wafer **802).** After forming the base (base wafer **700)** as shown in **FIGS. 7A-7H****,** the base (base wafer **700)** can be placed under the plurality of movable mirrors **100.** In some circumstances, the plurality of movable mirrors **100** is placed on the base (base wafer **700).** As shown, the base (base wafer **700)** includes a plurality of protrusions (mechanical stops **502,** support anchors **430).** As shown, when the base (base wafer **700)** is supporting the plurality of movable mirrors **100,** some of protrusions (mechanical stops **502)** on the base (base wafer **700)** overlap with central stages **220** in the first direction and some of the protrusions (support anchors **430)** on the base (base wafer **700)** overlap with support webbings 234 of the plurality of movable mirrors in the first direction. In a broad view, as shown in **FIG. 8****,** the mirror array **800** can be fabricated by bonding the base (base wafer **700)** to the device wafer **220'** (including the plurality of movable mirrors **100)** and bonding the device wafer **220'** to the lid (lid wafer **802).**

While preferred embodiments of the present invention have been shown and described herein, it will be obvious to those skilled in the art that such embodiments are provided by way of example only. Numerous variations, changes, and substitutions will now occur to those skilled in the art without departing from the invention. It should be understood that various alternatives to the embodiments of the invention described herein may be employed in practicing the invention. It is intended that the claims define the scope of the invention and that methods and structures within the scope of these claims and their equivalents be covered thereby.

This disclosure also refers to the following items.

**Item** 1. A mirror array, comprising: a lid; a base; a movable mirror between the lid and the base, the movable mirror including: a stationary frame including a cavity; a movable frame in the cavity; a central stage in the cavity; and a first protrusion on the base, wherein the first protrusion overlaps with the central stage in a first direction.

**Item** 2. The mirror array of item **1,** wherein the central stage includes a bottom portion facing the first protrusion.

**Item** 3. The mirror array of item **2,** wherein the first protrusion is spaced apart from the bottom portion of the central stage by a predetermined distance.

**Item** 4. The mirror array of item **3,** wherein the predetermined distance is between 3µm and 15µm.

**Item** 5. The mirror array of item **1,** further comprising: a second protrusion on the lid; and a third protrusion on the lid, wherein the second protrusion and the third protrusion extend towards the base.

**Item** 6. The mirror array of item **5,** further comprising: a first stationary frame flexure; a second stationary frame flexure, wherein the first stationary frame flexure and the second stationary frame flexure suspend the movable frame from the stationary frame.

**Item** 7. The mirror array of item **6,** wherein the second protrusion overlaps with the first stationary frame flexure in the first direction, and wherein the third protrusion overlaps with the second stationary frame flexure in the first direction.

**Item** 8. The mirror array of item **6,** wherein the second protrusion is apart from the first stationary frame flexure by a predetermined distance.

**Item** 9. The mirror array of item **8,** wherein the predetermined distance is between 3µm and 15µm.

**Item** 10. The mirror array of item 6, wherein the third protrusion is apart from the second stationary frame flexure by a predetermined distance.

**Item** 11. The mirror array of item 10, wherein the predetermined distance is between 3µm and 15µm.

**Item** 12. The mirror array of item 5, wherein the second protrusion and the third protrusion are non-overlapped with the central stage in the first direction.

**Item** 13. The mirror array of item 1, further comprising: a fourth protrusion on the base; and a fifth protrusion on the base, wherein the first protrusion is between the fourth protrusion and the fifth protrusion.

**Item** 14. The mirror array of item 13, wherein the fourth protrusion is configured to support a first support member, and wherein the fifth protrusion is configured to support a second support member.

**Item** 15. The mirror array of item 14, wherein the central stage includes a bottom portion extending towards the first protrusion, and wherein the bottom portion is between the first support member and the second support member.

**Item** 16. A mirror array, comprising: a movable mirror, the movable mirror including: a stationary frame including a cavity; a movable frame in the cavity, the movable frame suspended from the stationary frame by a first stationary frame flexure and a second stationary frame flexure; a central stage in the cavity; and a lid wafer covering the movable mirror; a first protrusion on the lid wafer, the first protrusion extended towards the movable mirror.

**Item** 17. The mirror array of item 16, wherein the first protrusion overlaps with the first stationary frame flexure in a first direction.

**Item** 18. The mirror array of item 16, wherein a gap between the first protrusion and the first stationary frame flexure is between 3µm and 15µm.

**Item** 19. The mirror array of item 16, further comprising a second protrusion on the lid wafer, wherein the second protrusion overlaps with the second stationary frame flexure in a first direction.

**Item** 20. The mirror array of item 19, wherein a gap between the second protrusion and the second stationary frame flexure is between 3µm and 15µm.

**Item** 21. The mirror array of item 16, further comprising: a base wafer; and a third protrusion on the base wafer, wherein the third protrusion overlaps with the central stage in a first direction.

**Item** 22. The mirror array of item 21, wherein the third protrusion is spaced apart from a bottom portion of the central stage by a predetermined distance.

**Item** 23. The mirror array of item 22, wherein the predetermined distance is between 3µm and 15µm.

**Item** 24. A fabrication method of mirror array, the method comprising: forming a plurality of movable mirrors that are spaced apart from each other, the plurality of movable mirrors including a first movable mirror, the first movable mirror including: a stationary frame including a cavity; a movable frame in the cavity, the movable frame suspended from the stationary frame by a first stationary frame flexure and a second stationary frame flexure; and a central stage in the cavity; forming a lid, the lid having a plurality of protrusions, the plurality of protrusions including a first protrusion and a second protrusion; covering the plurality of movable mirrors with the lid so that the first protrusion overlaps with the first stationary frame flexure in a first direction, and the second protrusion overlaps with the second stationary frame flexure in the first direction; forming a base, the base having a plurality of base protrusions, the plurality of base protrusions including a first base protrusion, supporting the plurality of movable mirrors with the base so that the first base protrusion overlaps with the central stage in the first direction.

**Item** 25. The fabrication method of mirror array of item 24, wherein forming the lid includes: bonding a silicon wafer to a glass wafer; disposing a hard mask layer on the silicon wafer; patterning the hard mask layer; disposing a photoresist layer on the patterned hard mask layer and the silicon wafer; patterning the photoresist layer to define locations of the plurality of protrusions; and etching the silicon wafer that is exposed;

**Item** 26. The fabrication method of mirror array of item 25, further comprising: removing the patterned photoresist layer; and etching the silicon wafer that is exposed after removing the patterned photoresist layer.

**Item** 27. The fabrication method of mirror array of item 24, wherein forming the base includes: disposing a hard mask layer on a base wafer; patterning the hard mask layer; disposing a photoresist layer on the patterned hard mask layer and the base wafer; patterning the photoresist layer to define locations of the plurality of base protrusions; and etching the base wafer that is exposed.

**Item** 28. The fabrication method of mirror array of item 27, further comprising: removing the patterned photoresist layer; and etching the base wafer that is exposed after moving the patterned photoresist layer

## Claims

1. A mirror array (800), comprising:
a movable mirror (100), the movable mirror (100) including:
a stationary frame (214) including a cavity (232);
a movable frame (227) in the cavity (232), the movable frame (227) suspended from the stationary frame (214) by a first stationary frame flexure (154) and a second stationary frame flexure (154);
a central stage (220) in the cavity (232); and
a lid wafer (802) covering the movable mirror (100);
a first protrusion (1012) on the lid wafer (802), the first protrusion (1012) extended towards the movable mirror (100).

2. The mirror array (800) of claim **1,** wherein the first protrusion (1012) overlaps with the first stationary frame flexure (154) in a first direction.

3. The mirror array (800) of claim **2,** wherein the first direction is a vertical direction.

4. The mirror array (800) of claim **1,** wherein a gap between the first protrusion (1012) and the first stationary frame flexure (154) is between 3µm and 15µm.

5. The mirror array (800) of any one of claims **1,** further comprising a second protrusion (1012) on the lid wafer (802), wherein the second protrusion (1012) overlaps with the second stationary frame flexure (154) in a first direction.

6. The mirror array (800) of claim **5,** wherein the first direction is a vertical direction.

7. The mirror array (800) of claim **5,** wherein a gap between the second protrusion (1012) and the second stationary frame flexure (154) is between 3µm and 15µm.

8. The mirror array (800) of any one of claims **1,** further comprising:
a base wafer (700); and
a third protrusion (502) on the base wafer (700), wherein the third protrusion (502) overlaps with the central stage (220) in a first direction.

9. The mirror array (800) of claim **8,** wherein the first direction is a vertical direction.

10. The mirror array (800) of claim **8,** wherein the third protrusion (502) is spaced apart from a bottom portion of the central stage (220) by a predetermined distance.

11. The mirror array (800) of claim **10,** wherein the predetermined distance is between 3µm and 15µm.
